# EUROPEAN PATENT SPECIFICATION

(11) **EP 0 733 286 B1**
(45) Date of publication and mention of the grant of the patent: **21.08.2002**
(21) Application number: 94916483.4
(22) Date of filing: 08.12.1993
(51) Int. Cl.: H03L 7/093

(54) **D/A FOR CONTROLLING AN OSCILLATOR IN A PHASE LOCKED LOOP**
DIGITAL ANALOG WANDLUNG ZUM STEUERN EINES OSZILLATORS IN EINEM PHASENREGELKREIS
CONVERTISSEUR NUMERIQUE/ANALOGIQUE COMMANDANT UN OSCILLATEUR DANS UNE BOUCLE A VERROUILLAGE DE PHASE

(43) Date of publication of application: 25.09.1996
(73) Proprietor: THOMSON CONSUMER ELECTRONICS, INC., Indianapolis, IN 46290-1024 (US)
(72) Inventor: ROMESBURG, Eric, Douglas, Raleigh, NC 27609 (US); RUMREICH, Mark, Francis, Indianapolis, IN 46236 (US)
(74) Representative: Kohrs, Martin
(86) International application number: US9311996
(87) International publication number: WO95016309

(56) References cited:
- EP-A- 0 523 887
- EP-A- 0 572 161
- GB-A- 2 110 031
- US-A- 4 563 657
- US-A- 5 050 195
- US-A- 5 159 292

## Description

This invention relates to Phase Locked Loops (PLL's), and more particularly to apparatus for generating a phase/frequency control signal of a controllable oscillator in the feedback loop.

Phase Locked Loops are circuits well known in the communications arts, for synchronizing a variable local oscillator with the phase and/or frequency of a component of a transmitted signal. Typically such circuitry includes a phase detector which is responsive to the transmitted signal and the output of the local oscillator, to generate a phase error signal proportional to the difference between a component of the transmitted signal and the oscillator output. The phase error signal is coupled to control the oscillator rate of the variable oscillator.

U.S. Patent 5,159,292 in the names of Canfield, et al., entitled, ADAPTIVE PHASE LOCKED LOOP describes a PLL for synchronizing a voltage controlled oscillator (VCO) to a subcarrier burst component in each active horizontal line of a composite video signal. A phase error signal digitally represented as a parallel phase error data word is applied via a digital-to-analog (D/A) converter to produce an analog signal having a magnitude that is determined by the value of the phase error data word. The analog signal that undergoes signal integration process is applied to control the phase/frequency of the VCO.

In one prior art, such D/A converter is realized using a pulse-width-modulator (PWM). During each horizontal line, the PWM generates a single pulse, when phase correction is required, having a pulse width that is modulated in accordance with the value of the phase error data word. The modulated pulse is applied to a charge pump arrangement. The charge pump arrangement charges/discharges an integrating capacitor, during the pulse. The change in the capacitor voltage is determined by the pulse width or the value of the phase error word. The capacitor voltage controls the VCO frequency. Disadvantageously, because only a single pulse occurs during each horizontal line, the size of the integrating capacitor may be relatively large.

For reducing the size of the integrating capacitor, a bit rate multiplier, embodying an inventive feature, is utilized as the D/A convener. The bit rate multiplier produces pulses at a higher frequency than the horizontal frequency. The bit rate multiplier includes a memory. The memory retains phase information of the pulses from each horizontal line to the immediately following one. Such an arrangement prevents errors in the analog output signal.

EP-A-0,572,161 discloses a circuit that automatically changes the gain in a phase locked loop for driving a motor of the type having a motor speed signal that indicates the speed of motor rotation. The circuit includes a phase detector for sensing a phase difference between the motor speed signal and a reference frequency and for producing an output signal of duration proportional to the sensed phase difference.

U.S. patent number 4,374,438 discloses an improved jitter-free system for phase locking a locally generated signal with a received signal. The system provides an arithmetic synthesizer having a clock signal source which clocks a binary increment contained in an input register into the digital accumulator of the arithmetic synthesizer.

The invention concerns a phase locked loop circuit that enables to improve the control of a generated oscillatory signal.

A phase locked loop circuit, embodying the invention, generates an oscillatory signal phase locked to a synchronizing component signal of an input signal. A controllable oscillator generates the oscillatory signal. A phase error signal that is indicative of a phase error of the oscillatory signal is generated. A first control signal having a frequency that varies in accordance with a magnitude of the phase error signal is generated. A filter responsive to the first control signal generates a filtered control signal that is coupled to the oscillator for varying a phase of the oscillatory signal , so that the filtered control signal's frequency varies the phase of the oscillatory signal.

According to the invention, the means responsive to the phase error signal are intended to generate the first control signal having pulses of equal pulse width and the filter is intended to generate the filtered control signal so that the filtered control signal's pulse width also varies the phase of the oscillatory signal.

The combined features of the claimed circuit enable an efficient control of the phase of the oscillatory signal.

Preferred circuit embodiments are given in the dependent claims 2 to 8.
FIGURE 1 illustrates a phase-lock-loop circuit including a digital-to-analog converter, embodying an aspect of the invention;
FIGURES 2a-2d illustrate waveforms useful for explaining the operation of the converter of FIGURE 1; and
FIGURE 3 illustrates a second embodiment of the converter of FIGURE 1.

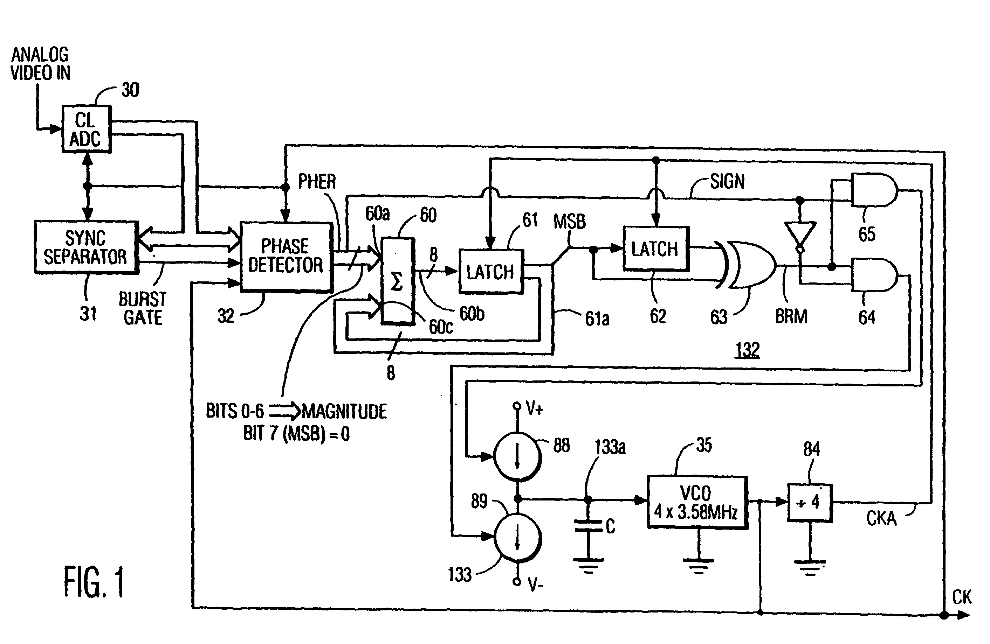

Referring to FIGURE 1, an analog video signal, from, for example, a television tuner, not shown, is applied to an analog-to-digital converter (ADC) 30. A digitized version of the analog signal is coupled from the output of the ADC to a horizontal synchronizing signal separator 31 and a phase detector 32. Separator 31 produces horizontal synchronizing pulses, which are coupled to phase detector 32, to condition the phase detector to operate in a phase measuring mode during chrominance reference burst intervals. Phase detector 32 is responsive to the digitized video signal compared in phase detector 32 to generate a phase error signal PHER. Signal PHER is, for example, an 8 bit binary word having, for example, a sign-magnitude format.

Signal PHER is coupled to a D/A converter 132, embodying an aspect of the invention, that includes a charge-pump 133. Charge-pump 133 charges/discharges an integrating capacitor C for producing an analog signal 133a in capacitor C. Signal 133a is used for controlling the relative phase of a voltage controlled oscillator (VCO) 35. Finally the VCO 35 generates a master clock signal CK at four times the subcarrier frequency, for example, for operating the other circuit elements. In the NTSC standard, such frequency is equal to 4x3.58 MHz. In particular the timing of the pulses of the master clock signal determine the instances at which the ADC 30 develop digital samples of the analog signal.

The way binary word signal PHER is generated may be similar to that described in the Canfield, et al., patent. Signal PHER is updated once each horizontal line period H at a predetermined instant controlled by a signal BURST GATE produced in separator 31. Signal BURST GATE is indicative of the occurrence of the burst signal component.

Seven magnitude bits of binary signal PHER, bits 0-6, are coupled to an input port 60a of a binary adder 60, with the 8th bit, that is the most significant bit, being zero. An 8-bit output signal 60b of adder 60 is coupled to an input port of a memory or latch 61. Latch 61 is updated once each period of a clock signal CKA. An output binary word signal 61a of latch 61 having 8 bits is coupled back to an input port 60c of adder 60. Signal 61a is equal to the sum of the magnitude portion of signal PHER and signal 61a.

A most significant bit signal MSB of signal 61a is coupled to a one-bit latch 62. Both latch 61 and latch 62 are clocked at a frequency of output clock signal CKA. Clock signal CKA has a period of approximately 280nSec and is produced by a divide-by-four frequency divider 84 from signal CK.

Signal MSB is coupled delayed, by the period of signal CKA, and undelayed to corresponding inputs of an Exclusive-OR gate 63 to produce bit rate multiplied signal BRM. Latch 62 and gate 63 produce signal BRM at the active HIGH state throughout the period of signal CKA following a change in state of signal MSB. If no state change occurs in signal MSB, signal BRM, in the following period of signal CKA, is at the inactive or LOW state. For a given number of magnitude bits, N, that is equal to 7 in the example of FIGURE 1, the maximum period of signal BRM is equal to 2^{N} periods of clock signal CKA.

In a first example, representing an extreme case, the phase error signal PHER is at a minimum magnitude with all the bits being at the LOW state. In this case, that is indicative of a zero phase error, word signal 60b remains constant in each period H and there is no change in signal MSB. Therefore, signal BRM is maintained at the inactive, LOW state.

In a second example, representing the other extreme case, assume that signal PHER is at its maximum value, or all the magnitude bits are at the HIGH state. This case represents magnitude value of 127 and is indicative of a maximum phase error. In this case, signal MSB will change states in each but one of every 128 consecutive periods of signal CKA because of the "wrapping" operation of adder 60. Therefore, signal BRM is maintained at the HIGH state in all but one of each of the 128 periods of signal CKA.

In a third example, assume, for explanation purposes, that the value of the magnitude bits of signal PHER is equal to 64 or one half the maximum magnitude that can be represented by signal PHER. In this case, signal BRM will alternate between the HIGH and LOW states following every period of signal CKA. The result is that, for a given interval such as the period H, the average "on" ratio between the times when signal BRM is at the HIGH state and the period H is proportional to the magnitude of signal PHER.

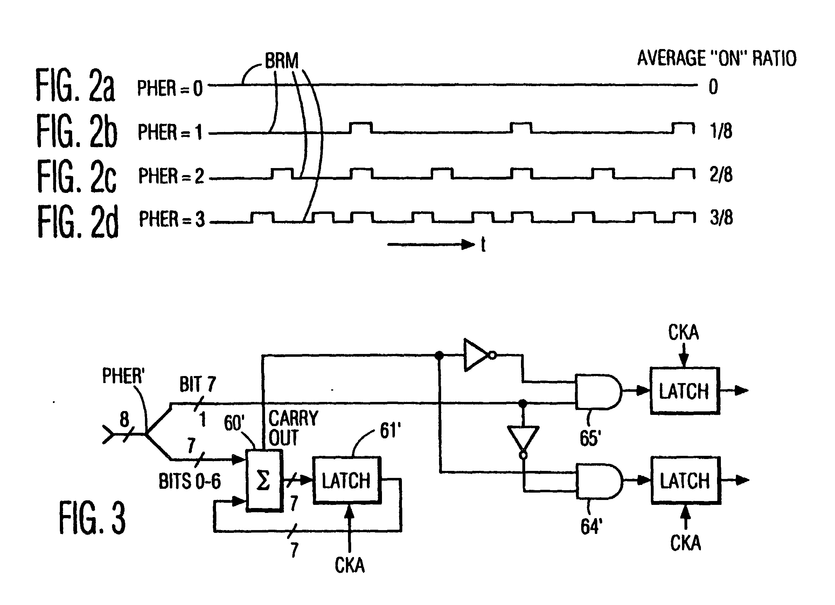

FIGURES 2a-2d illustrate four examples of the frequency of signal BRM resulting from signal PHER having magnitudes 0, 1, 2 and 3, respectively. For illustration purposes, FIGURES 2a-2d correspond to an arrangement that is similar to that in FIGURE 1 except that the number of magnitude bits, N, is equal to 3 instead of 7 as in the example of FIGURE 1. Similar symbols and numerals in FIGURES 1 and 2a-2d indicate similar items or functions.

When the magnitude of signal PHER of FIGURE 2d is 3, the average "on" ratio in a given interval, between the times when signal BRM is at the HIGH state and the period H is three-eighths. Such ratio corresponds to the ratio 3/2^{N}, where N=3 represents the number of magnitude bits.

As explained before, signal PHER of FIGURE 1 is updated once each horizontal line period H. However, updating signal PHER is not accompanied by initialization of latch 61. Therefore, latch 61 contains phase information of signal BRM that is carried over from one horizontal period H to the immediately following one.

In accordance with an inventive feature, by carrying over the phase information of signal BRM and not initializing latch 61, the aforementioned average "on" ratio is made independent of a ratio between a maximum period of signal BRM, that is equal to 128 periods of signal CKA for 7 bits, and the period between consecutive updating of signal PHER, that is equal to horizontal period H. It can be shown that when the updating period such as period H is not equal to an integer multiple of the maximum period of signal BRM, initialization of latch 61 in each updating period H could introduce an error in analog signal 133a.

FIGURE 3 illustrates a second embodiment of a portion of D/A converter 132 of FIGURE 1. Similar symbols and numerals in FIGURES 1, 2a-2d and 3 indicate similar items or functions except for the prime symbol. In FIGURE 3, signal PHER' is represented as a two's complement number rather than a sign-magnitude. Signal BRM' is obtained as a carry out signal of adder 60'.

When signal BRM of FIGURE 1 is at the HIGH state and a signal SIGN, that represents the sign of signal PHER, is at the HIGH state, an AND gate 65 enables a positive current source 88 to charge capacitor C. On the other hand, when signal SIGN is at the LOW state and signal PHER is at the HIGH state, an AND gate 64 enables a negative current source 89 to discharge capacitor C. As long as signal BRM is, at the LOW state, both current sources 88 and 89 are disabled and capacitor C is neither charged nor discharged. The frequency of signal BRM is higher than the horizontal frequency when, for example, the magnitude of the phase error signal PHER is large. Therefore, advantageously, the size of capacitor C need not be as large as in a prior art arrangement in which the D/A converter operates as a pulse-width modulator type instead of, as in the arrangement of FIGURE 1, as a bit rate multiplier.

For a given value of capacitor C, the peak-to-peak VCO control voltage ripple can be reduced. Smaller ripple leads to more consistent clock frequency over the horizontal line period or less distortion of tint. This scheme also provides more freedom to choose an integration capacitor based on the desired bandwidth of the loop, since it has less filtering to do concerning ripple on the VCO control voltage. In this way, the loop can be made faster without sacrificing VCO control voltage ripple.

## Claims

1. A phase locked loop circuit for generating an oscillatory signal (CK) phase locked to a synchronizing component signal of an input signal, said phase locked loop circuit including:
- a controllable oscillator (35) for generating said oscillatory signal;
- means (32) responsive to said component and oscillatory signals for generating a phase error signal (PHER) that is indicative of a phase error of said oscillatory signal (CK);
- means (60-63) responsive to said phase error signal (PHER) for generating a first control signal (BRM) having [pulses of equal pulse width and] a frequency that varies in accordance with a magnitude of said phase error signal (PHER); and
- a filter (C) responsive to said first control signal (BRM) for generating a filtered control signal (133a) that is coupled and applied to said oscillator (35) for varying a phase of said oscillatory signal (CK), so that said filtered first control signal's frequency varies the phase of said oscillatory signal (CK);
**characterized in that** the means (60-63) responsive to said phase error signal (PHER) generate the first control signal (BRM) having pulses of equal pulse width and that said filter (C) generates the filtered control signal (133a) so that said filtered first control signal's pulse width also varies the phase of said oscillatory signal (CK).

2. A phase locked loop circuit according to Claim 1 wherein said error signal (PHER) is represented in a digital format and wherein said first control signal generating means (60,61) comprises a bit rate multiplier (60,61).

3. A phase locked loop circuit according to Claim 2 wherein said bit rate multiplier (60,61) is coupled to a charge pump arrangement (88,89) to form a digital-to-analog converter.

4. A phase locked loop circuit according to Claim 2 wherein said first control signal generating means (60-63) comprises an accumulator (61) responsive to a clock signal (CKA) for accumulating data of said error signal (PHER) at a rate that is determined by a rate of said clock signal and means (62,63) responsive to an accumulated data signal (61a) in said accumulator for generating a given pulse of said first control signal (BRM) when said accumulated data signal is at a predetermined magnitude.

5. A phase locked loop circuit according to Claim 4 wherein said error signal (PHER) is updated in steps that occur periodically and wherein said accumulator (61) combines the updated error signal that is applied to said accumulator following a given updating step with the accumulated data signal (61a) contained in said accumulator that is obtained prior to said updating step without initializing said accumulated data signal.

6. A phase locked loop circuit according to Claim 5 wherein the absence of initialization of said accumulated data signal (61a) reduces a dependency of said filtered control signal (133a) on a ratio between a length of an interval between updating steps (H-horizontal period) and a period of said first control signal (BRM).

7. A phase locked loop circuit according to Claim 5 wherein said error signal (PHER) is updated once during a horizontal period of a television signal (H).

8. A phase locked loop circuit according to claim 1, **characterized in that**:
- the means (32) responsive to said component and oscillatory signals are intended to generate the phase error signal (PHER) that is periodically updated in steps in accordance with a clock signal (BURST GATE); and
- the means (60-63) responsive to said updated phase error signal (PHER) are intended to generate the first control signal (BRM) such that a phase of the pulses of said first control signal (BRM) following a given updating step is determined by both said updated phase error signal that is associated with said given updating step and said updated phase error signal that is associated with a preceding updating step.

9. A phase locked loop circuit according to Claim 8 wherein said pulses (BRM) are of equal pulse width.

## Patentansprüche

1. Schaltung einer phasenverkoppelten Schleife zum Erzeugen eines Oszillatorsignals (CK), das mit einer Synchronisiersignalkomponente eines Eingangssignals phasenverkoppelt ist, mit:
- einem steuerbaren Oszillator (35) zum Erzeugen des Oszillatosignals,
- Mitteln (32), die auf die Signalkomponente und das Oszillatorsignal ansprechen, zum Erzeugen eines Phasenfehlersignals (PHER), das einen Phasenfehler des Oszillatorsignals (CK) anzeigt,
- auf das Phasenfehlersignal (PHER) ansprechenden Mitteln (60-63) zum Erzeugen eines ersten Steuersignals (BRM) mit [Impulsen gleicher Impulsbreite und] einer Frequenz, die sich entsprechend der Größe des Phasenfehlersignals (PHER) ändert, und
- einem auf das erste Steuersignal (BRM) ansprechenden Filter (C) zum Erzeugen eines gefilterten Steuersignals (133a), das dem Oszillator (35) zur Änderung der Phase des Oszillatorsignals (CK) zugeführt wird, so daß die Frequenz des gefilterten ersten Steuersignals die Phase des Oszillatorsignals (CK) ändert,
**dadurch gekennzeichnet, daß**
die auf das Phasenfehlersignal (PHER) ansprechenden Mittel (60-63) das erste Steuersignal (BRM) mit gleicher Impulsdauer erzeugen und daß das Filter (C) das gefilterte Steuersignal (133a) derart erzeugt, daß die Impulsbreite des gefilterten ersten Steuersignals ebenfalls die Phase des Oszillatorsignals (CK) ändert.

2. Schaltung einer phasenverkoppelten Schleife nach Anspruch 1, wobei das Fehlersignal (PHER) in einem digitalen Format dargestellt wird und die Mittel (60, 61) zum Erzeugen des ersten Steuersignals einen Bitraten-Vervielfaher (60, 61) enthalten.

3. Schaltung einer phasenverkoppelten Schleife nach Anspruch 2, wobei der Bitraten-Vervielfacher (60, 61) mit einer Anordnung (88, 89) einer Ladungspumpe verbunden ist, um einen Digital/Analog-Konverter zu bilden.

4. Schaltung einer phasenverkoppelten Schleife nach Anspruch 2, wobei die Mittel (60-63) zum Erzeugen des Steuersignals einen auf ein Taktsignal (CKA) ansprechenden Akkumulator (61) zum Akkumulieren der Daten des Fehlersignals (PHER) bei einer Rate, die durch die Rate des Taktsignals bestimmt ist, und auf ein akkumuliertes Datensignal (61a) in dem Akkumulator ansprechende Mittel (62, 63) zum Erzeugen eines bestimmten Impulses des ersten Steuersignals (BRM) enthalten, wenn sich das akkumulierte Datensignal bei einer vorbestimmten Größe befindet.

5. Schaltung einer phasenverkoppelten Schleife nach Anspruch 4, wobei das Fehlersignal (PHER) in Schritten aktualisiert wird, die periodisch erscheinen, und wobei der Akkumulator (61) das aktualisierte Fehlersignal kombiniert, das dem Akkumulator zugeführt wird, gefolgt von einem bestimmten Aktualisierungsschritt mit dem in dem Akkumulator enthaltenen akkumulierten Datensignal (61a), das vor dem Aktualisierungsschritt ohne Initialisierung des akkumulierten Datensignals gewonnen wird.

6. Schaltung einer phasenverkoppelten Schleife nach Anspruch 5, wobei die Abwesenheit der Initialisierung des akkumulierten Datensignals (61a) die Abhängigkeit des gefilterten Steuersignals (133a) von dem Verhältnis zwischen der Länge eines Intervalls zwischen den Aktualisierungsschritten (Horizontalperiode H) und einer Periode des ersten Steuersignals (BRM) verringert.

7. Schaltung einer phasenverkoppelten Schleife nach Anspruch 5, wobei das Fehlersignal (PHER) einmal während einer Horizontalperiode (H) eines Femsehsignals aktualisiert wird.

8. Schaltung einer phasenverkoppelten Schleife nach Anspruch 1, **dadurch gekennzeichnet, daß**
- die auf die Signalkomponente und das Oszillatorsignal ansprechenden Mittel (32) das Phasenfehlersignal (PHER) erzeugen, das in Schritten gemäß einem Taktsignal (BURST TOR) periodisch aktualisiert wird, und
- die auf das aktualisierte Phasenfehlersignal (PHER) ansprechenden Mittel (60-63) das erste Steuersignal (BRM) derart erzeugen, daß die Phase der Impulse des ersten Steuersignals (BRM), die auf einen bestimmten Aktualisierungsschritt folgen, durch das aktualisierte Phasenfehlersignal, das zu dem bestimmten Aktualisierungsschritt gehört, und das aktualisierte Phasenfehlersignal bestimmt ist, das zu einem vorangehenden Aktualisierungsschritt gehört.

9. Schaltung einer phasenverkoppelten Schleife nach Anspruch 8, wobei die Impulse (BRM) gleiche Impulsbreite aufweisen.

## Revendications

1. Circuit de boucle à verrouillage de phase pour générer un signal oscillant (CK) asservi en phase par une composante de synchronisation d'un signal d'entrée, ledit circuit de boucle à verrouillage de phase comprenant:
- un oscillateur pouvant être commandé (35) pour générer ledit signal oscillant;
- un moyen (32) qui réagit à ladite composante et aux dits signaux oscillants pour générer un signal d'erreur de phase (PHER) qui indique une erreur de phase dans ledit signal oscillant (CK);
- un moyen (60 à 63) qui réagit audit signal d'erreur de phase (PHER) pour générer un premier signal de commande (BRM) dont la fréquence varie en fonction de l'amplitude dudit signal d'erreur de phase (PHER); et
- un filtre (C) qui réagit audit premier signal de commande (BRM) pour générer un signal de commande filtré (133a) qui est appliqué audit oscillateur (35) pour faire varier la phase dudit signal oscillant (CK) de façon à ce que la fréquence dudit premier signal de commande filtré fasse varier la phase dudit signal oscillant (CK);
**caractérisé en ce que** le moyen (60 à 63) qui réagit audit signal d'erreur de phase (PHER) génère le premier signal de commande (BRM) dont les impulsions sont de largeur égale et **en ce que** ledit filtre (C) génère le signal de commande filtré (133a) de façon à ce que la largeur d'impulsion dudit premier signal de commande filtré fasse également varier la phase dudit signal oscillant (CK).

2. Circuit de boucle à verrouillage de phase selon la revendication 1, dans lequel ledit signal d'erreur (PHER) est représenté en format numérique et dans lequel le moyen de génération dudit premier signal de commande (60, 61) comprend un multiplicateur de débit binaire (60, 61).

3. Circuit de boucle à verrouillage de phase selon la revendication 2 dans lequel ledit multiplicateur de débit binaire (60, 61) est connecté à une pompe à charge (88, 89) pour constituer un convertisseur numérique- analogique.

4. Circuit de boucle à verrouillage de phase selon la revendication 2, dans lequel le moyen de génération dudit premier signal de commande (60à 63) comporte un accumulateur (61) qui réagit à un signal d'horloge (CKA) pour cumuler des données dudit signal d'erreur (PHER) à une fréquence qui est déterminée par la fréquence dudit signal d'horloge et un moyen (62, 63) qui réagit à un signal de données cumulées (61a) contenu dans ledit accumulateur pour générer une impulsion donnée dudit premier signal de commande (BRM) quand ledit signal de données cumulées a une amplitude prédéterminée.

5. Circuit de boucle à verrouillage de phase selon la revendication 4, dans lequel ledit signal d'erreur (PHER) est mis à jour par étapes intervenant périodiquement et dans lequel ledit accumulateur (61) combine le signal d'erreur mis à jour, qui est appliqué audit accumulateur à la suite d'une étape de mise à jour donnée, avec le signal de données cumulées (61a) contenu dans ledit accumulateur, qui est obtenu avant l'étape de mise à jour sans initialiser ledit signal de données cumulées.

6. Circuit de boucle à verrouillage de phase selon la revendication 5, dans lequel l'absence d'initialisation dudit signal de données cumulées (61a) réduit la dépendance dudit signal de commande filtré (133a) vis-à-vis d' un rapport entre la longueur d'un intervalle, entre les étapes de mise à jour (H- période horizontale), et une période dudit premier signal de commande (BRM).

7. Circuit de boucle à verrouillage de phase selon la revendication 5, dans lequel ledit signal d'erreur (PHER) est mis à jour une fois par période horizontale d'un signal de télévision (H).

8. Circuit de boucle à verrouillage de phase selon la revendication 1, **caractérisé en ce que**:
- le moyen (32) qui réagit à la dite composante et aux dits signaux oscillants est destiné à générer le signal d'erreur de phase (PHER) qui est périodiquement mis à jour par étapes en fonction d'un signal d'horloge (BURST GATE); et
- le moyen (60 à 63) qui réagit audit signal d'erreur de phase mis à jour (PHER) est destiné à générer le premier signal de commande (BRM) de façon à ce que la phase des impulsions dudit premier signal de commande (BRM) qui suit une étape de mise à jour donnée soit déterminée à la fois par ledit signal d'erreur de phase mis à jour qui est associé à la dite étape de mise à jour donnée et par ledit signal d'erreur de phase mis à jour qui est associé à la précédente étape de mise à jour.

9. Circuit de boucle à verrouillage de phase selon la revendication 8 dans lequel lesdites impulsions (BRM) sont de largeur égale.
